# EUROPEAN PATENT SPECIFICATION

(11) **EP 0 577 264 B1**
(45) Date of publication and mention of the grant of the patent: **01.12.1999**
(21) Application number: 93304170.9
(22) Date of filing: 28.05.1993
(51) Int. Cl.: H01L 25/07, H01L 23/495

(54) **A semiconductor device comprising a plurality of semiconductor chips**
Halbleiteranordnung mit mehreren Halbleiterchips
Dispositif semi-conducteur comprenant une pluralité de puces semi-conductrices

(30) Priority: 29.06.1992 JP 16973092
(43) Date of publication of application: 05.01.1994
(73) Proprietor: FUJI ELECTRIC CO. LTD., Kawasaki 210 (JP)
(72) Inventor: Murakami, Yukio, Higashi-tukumagun, Nagano 390-14 (JP)
(74) Representative: Bridge-Butler, Alan James

(56) References cited:
- EP-A- 0 292 848
- EP-A- 0 455 322
- DE-A- 2 819 327
- FR-A- 2 395 603

## Description

The present invention relates to a resin-sealed semiconductor device that uses diode modules, thyristor modules, or power transistor modules.

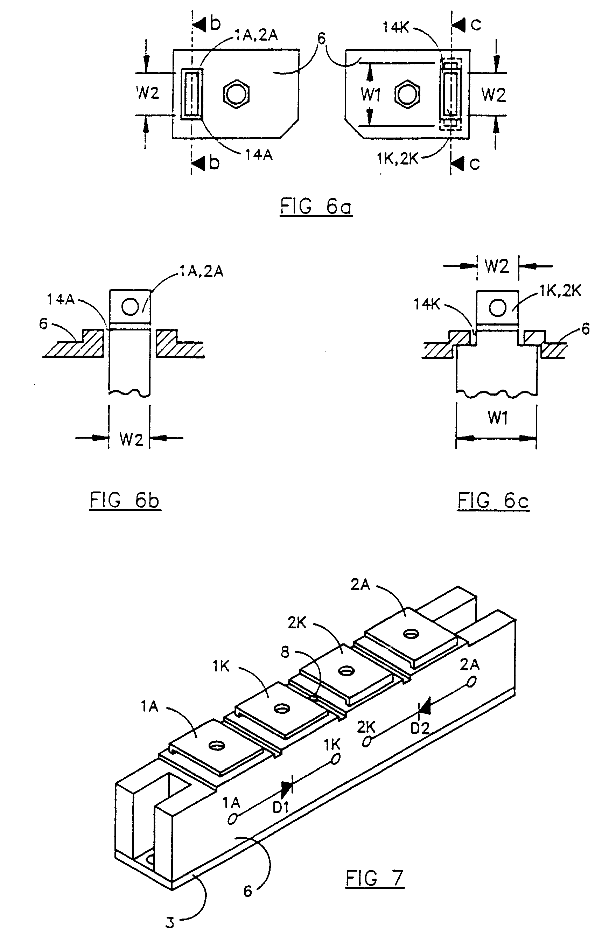

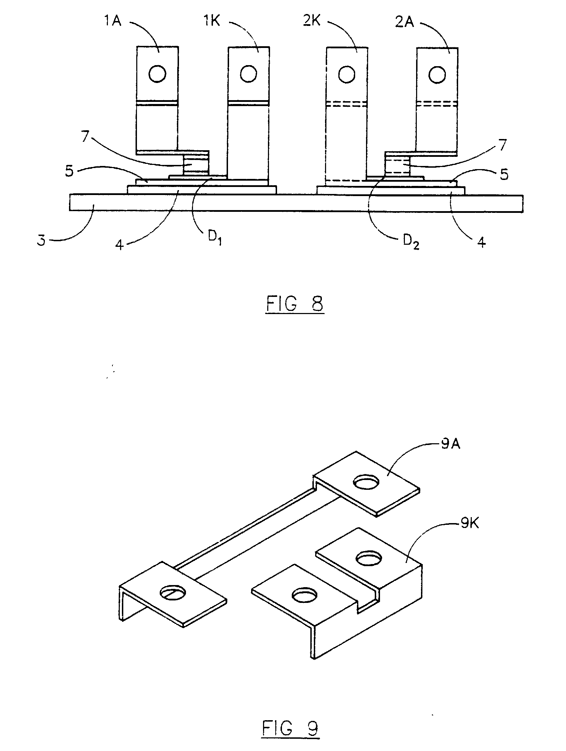

A conventional construction of a resin-sealed semiconductor device as described in JP-A-59 110 141 will first be explained, taking a two-set diode module as an example and referring to Figures 7 and 8 of the drawings. In these Figures, D1 and D2 are two diode chips assembled into a module, and 1A, 1K, 2A, and 2K are externally drawn terminals connected respectively to the anode electrode and the cathode electrode of the respective diode chips D1 and D2, and are drawn out therefrom. Said diode chips D1 and D2 are each solder-mounted on a respective chip base 5 which is a copper plate larger than the diode chip, and the chip bases 5 are laminated on a heat-dissipating metal base 3 via an insulation substrate 4, the metal base 3 being provided with an enclosing case 6 surrounding said parts. Among said externally drawn terminals 1A, 1K, 2A and 2K, the externally drawn terminals 1K and 2K on the cathode electrode are formed by being drawn upward and being coupled with the chip base 5, the externally drawn terminals 1A and 2A on the anode electrode are solder-bonded with the main upper face of the diode chips D1 and D2 via C-shaped connecting pieces 7, and each externally drawn terminal is led out to the top surface of the case by passing through an upper lid on the case 6, and are laid in one row in the order 1A, 1K, 2K and 2A from left to right as seen in Figure 7.

The case 6 is filled with a moulding or 'potting' resin (epoxy resin for example) to seal the parts, including the diode chips assembled in the modules. The moulding resin is injected into the case through a resin-injection hole at the centre of the top of the case after the case 6 has been bonded to the metal base 3.

Conventional modules constructed as described above have the following handling and assembly drawbacks:

Firstly, if two-set diodes D1 and D2 assembled in a module are to be used by being connected in parallel, for example, since the externally drawn terminals 1A, 1K, 2K and 2A of each diode chip are arranged in one line along the case, these diodes must be interconnected via two different types of external connecting pieces 9A and 9K, each having a relatively complex shape as shown in Figure 9, which results in an increase in manufacturing costs.

Secondly, the externally drawn terminals 1A, 1K, 2K and 2A laid in one line from left to right all have the same conductor width, and the enclosing case 6 fitted onto these externally drawn terminals has a symmetrical shape. This structure makes it possible for the case 6 to be mounted accidentally in a reverse direction when the case 6 is attached to the metal base during the assembly process. Moreover, because the enclosing case 6 has diode terminal symbols already marked on it prior to assembly, the actual externally drawn terminals may not match the terminal symbols if the case is accidentally mounted in a reverse direction.

A further drawback is that when moulding resin is injected into the enclosing case after the parts have been assembled, the externally drawn terminals laid in the case form obstacles to prevent the injected resin from flowing freely within the case. This causes an inconvenience in that an insufficient amount of resin may be injected, and the resin-filling operation will take more time.

Finally the connecting pieces 7, which are separate parts, are disposed on the anode electrode side of the diode chips between the diode chips and the externally drawn terminals in order to absorb stress caused as a result of the difference in the thermal expansion of the moulding resin and the externally drawn terminals. This arrangement increases the number of parts and thus the number of man-hours required for soldering and assembly, causing an increase in costs.

The present invention has been made with the above problems in mind, and its objective is to solve each of the above problems, while providing a semiconductor device construction that will offer advantages in terms of assembly, handling and manufacturing costs.

To achieve the above objective, the present semiconductor device is configured to have a different terminal arrangement, as will be described below.

According to the present invention, there is provided a semiconductor device consisting of a plurality of semiconductor chips contained within an enclosing case filled with moulding resin and having electrical terminals of a first and second polarity connected to respective main electrodes of each semiconductor chip, each of said terminals of the first polarity comprising a chip base and a portion perpendicular to said chip base, said portion further comprising a riser part and an externally drawn terminal; each of said terminals of the second polarity comprising a terminal leg and a portion perpendicular to said terminal leg, said portion further comprising a rising part and an externally drawn terminal; said electrical terminals are arranged side by side and said externally drawn terminals are drawn out through the top of the case, wherein the externally drawn terminals of the first polarity are arranged in a first straight line while the externally drawn terminals of the second polarity are arranged in a second straight line parallel to the first straight line, and wherein the externally drawn terminals of different polarities of each respective semiconductor chip are arranged in a row extending perpendicularly to said straight lines; wherein the width of said riser part and the width of said rising part are different from each other; wherein terminal drawing slots are disposed in said top of the case having sizes corresponding individually to said widths of said riser and rising parts; wherein each semiconductor chip is mounted on said chip base of said terminal of first polarity, and each externally drawn terminal of second polarity is linked with the top of each of said semiconductor chips; and wherein notches, which function as paths for the sealing resin injected into the case, are formed on the riser part of said terminals of first polarity.

According to this configuration, if the built-in semiconductors are used and are connected in parallel, and because the externally drawn terminals with the same polarity are arranged on one straight line at the top of the case, then the externally drawn terminals with the same polarity can be interconnected without interference from the externally drawn terminals of different polarities, by the use of simple strip-shaped conductor bars as externally connecting parts.

Because the widths of the riser part and the rising part are of different dimensions from each other, while the terminal drawing slots are disposed in the top of the case and are dimensioned to correspond individually to the widths of the riser and rising parts, where the enclosing case is mounted by being fitted into the externally drawn terminals, even if the case-attaching direction is mistaken and the case is offered up with the horizontal direction in reverse, the widths of the conductors on the externally drawn terminals do not match the widths of the slots for drawing the terminals disposed in the case side, which makes it impossible to assemble the case to the base. In other words, the case-attaching direction is so regulated that errors in attaching the case during the assembly process can be precluded.

Because notches are formed on the riser part of the terminals of first polarity, which will in practice have a wider conductor width than the terminals of second polarity, the notches act to reduce the fluid resistance of the moulding resin. Consequently, the moulding resin injected into the enclosing case flows smoothly, preventing possible defects resulting from insufficient resin filling.

In a further advantageous development, chip connecting parts bent in a C-shape are integrally formed at the terminal legs of said terminals of second polarity, said chip connecting parts being soldered on said main electrodes of the semiconductor chips.

According to this configuration, because the externally drawn terminals and the stress-absorbing connecting parts for the chip are formed integrally, semiconductor assembly involves fewer parts thereby decreasing the number of man-hours required for assembly. Furthermore, the configuration in which the chip connecting parts are formed in a branch and are connected by being drawn from the semiconductor side of the externally drawn terminals in the lateral direction, for example, semiconductor chips for one semiconductor are divided into various chips for a parallel connection can be handled simply by increasing the number of branches in the chip connecting parts according to the arrangement of each chip.

Resin-injection holes for filling the case with resin may be disposed discretely at two or more sites at the top of the case, on which the rows of the externally drawn terminals are positioned. Thus, when the moulding resin is injected into the enclosing case, the resin can fill every corner of the case in a short time by simultaneously injecting the resin from various resin-injecting holes on the case. Furthermore, if the shape and size of each resin-injecting hole is made visually appreciably different, this ensures that an assembly worker will be able to determine without error the polarity and the arrangement of the terminals by just observing the arrangement of the resin-injecting holes on the top of the case. If the worker has recognized the relationship between the polarity and arrangement of the terminals and the arrangement of the resin-injecting holes before he begins the assembly work, he can assemble the same products into different devices, without the need to visually verify the polarity of the terminals one by one by using the terminal symbols indicated on the case (generally terminal symbols are marked on the side of a case in small letters which are difficult to see).

The resin-injection holes may be formed with different shapes and sizes so that they can be easily visually discriminated.

Embodiments of the present invention will now be explained with reference to the drawings, in which:
Figure 1 is a plan view showing a configuration of one embodiment of the present invention applied to a two-set diode module;
Figure 2 is a plan view of an internal construction shown in Figure 1, in which the enclosing case has been removed;
Figure 3 is a side view of the diode module of Figure 2;
Figure 4 shows the construction of externally drawn terminals on cathode electrodes of the modules of Figure 1, Figures 4a and 4b being perspective outline views of different configurations;
Figure 5 is a drawing to show the construction of an externally drawn terminal on an anode electrode of the module shown in Figure 1, Figure 5a being the relevant perspective outline view and Figure 5b being a view of the blank prior to bending into shape;
Figure 6 is a drawing to show the construction of terminals extending through the enclosing case, Figure 6a being a plan view, and Figures 6b and 6c showing the relative cross-sections along the lines b-b and c-c in Figure 6a;
Figure 7 is a perspective outline view showing the assembly configuration in a conventional two-set diode module;
Figure 8 is a side view to illustrate the internal construction of the module of Figure 7; and
Figure 9 is a perspective view showing the external connecting conductor pieces used to interconnect two sets of diodes in the module of Figures 7 and 8 in parallel.

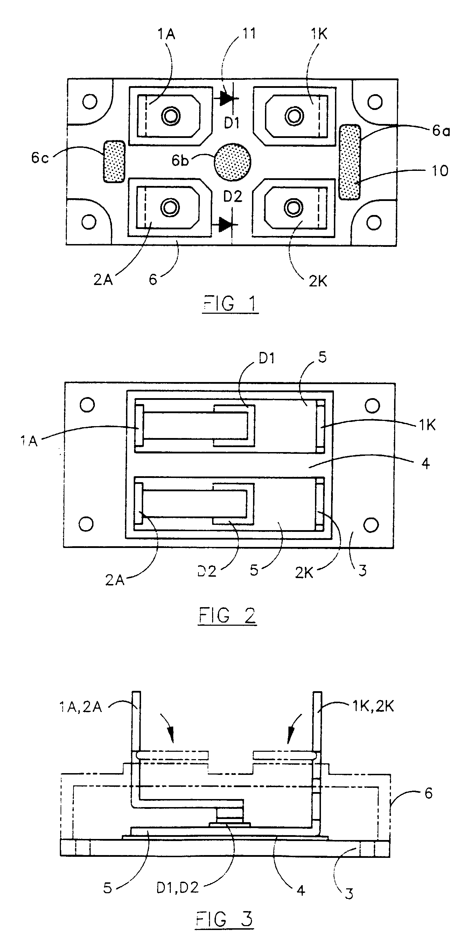

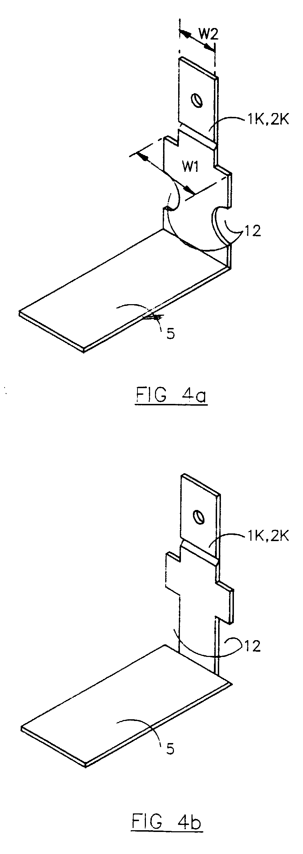

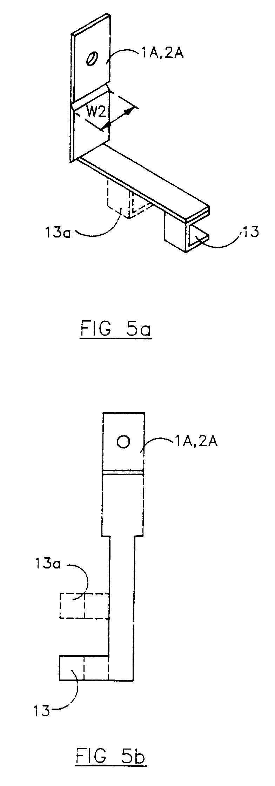

The embodiments illustrated in the Figures are two-set diode modules. Figure 1 is a top view of a diode module, Figure 2 is a plan view of the internal structure with the enclosing case removed for clarity, and Figure 3 is a side view of the structure shown in Figure 2. Figures 4 and 5 show the structure of the externally drawn terminals, and Figure 6 shows the structure of slots formed in the enclosing case for the egress of the terminals. In the figures, the parts identical to those in Figures 7 and 8 given the same numerals. In the figures, diode chips D1 and D2 are mounted on chip bases 5 laid in two rows, wherein externally drawn terminals 1A and 2A leading from anode electrodes are drawn out to the left of the chip base 5 and externally drawn terminals 1K and 2K leading from the cathode electrodes are drawn out to the right, sandwiching the diode chips D1 and D2 respectively, said parts being disposed on top of an enclosing case 6 separately. As can be seen in Figure 1, the externally drawn terminals 1A and 2A from the anode electrodes and the externally drawn terminals 1K and 2K from the cathode electrodes, which have the same polarity, are arranged in respective straight lines, while the terminal row comprising terminals 1A and 1K and the terminal row comprising terminals 2A and 2K, which have different polarities, are arranged in parallel.

With such a structure, where two sets of the diode chips D1 and D2 assembled in a module are used, being connected in parallel externally to the module, the externally drawn terminals 1A and 2A on the anode electrodes and the externally drawn terminals 1K and 2K on the cathode electrodes laid on straight lines can be interconnected easily by using only one kind of simple strip-shaped conductor bar without the need to use external connecting pieces with a complex shape such as used in a conventional structure, which is shown in Figure 9.

In addition, resin-injecting holes 6a, 6b and 6c are formed in top of the case 6 at three positions -- on the right edge, at the centre and on the left edge corresponding to the arrangement of said externally drawn terminals. As illustrated, for example, the resin-injection hole 6a at the right edge close to the externally drawn terminals 1K and 2K is a rectangular hole with a relatively large area, the resin-injection hole at the centre is a round hole, and the resin-injection hole 6c at the left edge close to the externally drawn terminals 1A and 2A is a rectangular hole with a relatively small area, all the holes preferably being given different shapes and sizes. When the moulding resin is injected into the enclosing case 6, it is injected from said resin-injection holes 6a, 6b and 6c simultaneously. The part 10 is the moulding resin filled into the case, and 11 is a mark marked on the case 6, which indicates the rectifying direction of the diode chip.

According to this configuration, when filling the moulding resin into the enclosing case 6, the resin can be injected efficiently into every corner of the case in a short time by simultaneously injecting the resin from the resin-injecting holes 6a, 6b and 6c opened at various positions on the case. Furthermore, when completed products are attached to different devices, the assembly work can be carried out efficiently by observing the arrangement direction of the terminal polarities according to the arrangement pattern of the resin-injecting holes 6a, 6b and 6c, which have different shapes and sizes, by initially recognizing the relationship between the arrangement of said resin-injecting holes and the terminals' polarities and arrangements, without the need to check the terminal symbol marks indicated on the cases one by one (which are very small and difficult to see) during the assembly work.

At the same time, the externally drawn terminals 1K and 2K on the cathode electrodes assembled in the case are integrated with the chip base 5 as shown in a and b in Figure 4, and notches 12 are formed on both sides of the terminal to reduce the width of the riser part of the terminal adjacent the chip base. As can be seen, without the notches 12 the width W1 of the terminal would be identical to that of the chip base 5, which is wider than that of diode chips D1 and D2. Since the notches 12 function to enlarge the available flow paths for the moulding resin when it is injected into the enclosing case through the resin-injecting hole 6a described earlier, the resin can be injected smoothly into every corner of the case without being greatly disrupted by the externally drawn terminal. At the same time, because the resin that has entered the notches 12 has an anchoring effect, the resin is bonded more strongly with the externally drawn terminals 1K and 2K. In addition, the tip portion of a terminal drawn through the case 6 to above the case has its conductor width W2 narrowed such that W2 < W1.

In contrast, the externally drawn terminals 1A and 2A on the anode electrodes are structured as shown in Figures 5 a and b. That is, the terminals have their W2 conductor width at the rising part, and a chip-connecting part 13 bent in C-shape is formed integrally at the tip of the terminal leg. This bent chip-connecting part 13 plays an important role in absorbing and easing stress imposed as a result of the heat cycles resulting from the difference in the heat expansion factors of the moulding resin and the terminal metal, as well as preventing the stress from acting directly on the diode chips via the externally drawn terminals. The connecting part 13 is moulded and formed so that it protrudes from the conductor side of the externally drawn terminals 1A and 2A as can be seen in the expanded view in Figure 5b.

Furthermore, a semiconductor device may be structured so that, with respect to the two sets of the diode chips D1 and D2, each diode chip set is divided into two or more chip pieces to be mounted on the chip base 5 in parallel, and the anode electrodes for each chip piece are drawn out and connected in parallel with the externally drawn terminals lA and 2A. Particularly with diode module with large current capacity set in a variety of ways, wherein one chip (with its generally square shape) is employed by each set to be disposed side by side in the case, the width occupied by the chips should be increased, which leads to an increased case size. However, if each set of chips is divided into various chips and is laid in one longitudinal row, the width occupied by the chips can be reduced even when the current capacity is the same, so that the product size can be reduced. According to the terminal construction in Figure 5 with the above chip construction, the chip arrangement can be varied simply by disposing another chip-connecting part 13a branched from the externally drawn terminals 1A and 2A, as shown by the dashed lines in the figure.

Next, the slots formed in the enclosing case 6 to draw out the externally drawn terminals are explained with reference to Figure 6. First, the externally drawn terminals 1K and 2K on the cathode electrodes and the externally drawn terminals 1A and 2A on the anode electrodes have conductor widths set to W1 and W2 at the riser and rising parts as described earlier, and the terminal slots 14A and 14K disposed on the top of the enclosing case 6 correspond to the conductor widths W1 and W2 and are arranged as follows. That is, the slot 14A on the left side, which is used to draw out the externally drawn terminals 1A and 2A on the anode electrodes, is set to a width corresponding to the conductor width W2 in the externally drawn terminal as shown in Figure 6b, while the other slot 14K, which are used to draw out the externally drawn terminals 1K and 2K on the cathode electrodes, are formed as stepped slots, the widths of the steps being dimensioned to match the conductor width W1, W2 as shown in Figure 6c.

Consequently, when attaching the terminals to the enclosing case 6, if the case is fixed correctly, the slots 14A and 14K can fit the externally drawn terminals 1A, 2A and 1K, 2K, and the case 6 can be mounted. However, if a case is offered up incorrectly in reverse and mounting is attempted, the case cannot be set into place because of the difference in the sizes of the slots. This makes it possible to avoid defects in a product due to an assembly mistake in the case-attaching process, and the completed product will of necessity have a polarity-indicating mark 11, which is shown in Figure 1, which correctly matches the polarities of the externally drawn terminals 1A, 2A, 1K and 2K are arranged on the top of the case.

Although the illustrated embodiments have been explained for a two-set diode module, it is clear that an equivalent effect can be obtained even if the number of chips to be assembled in a diode module is three or more. It is also evident that the embodiments can be applied to modules other than the diode module, such as a thyristor module and power transistor module, for example.

As is clear from the foregoing explanation, the embodiments of the present invention described above have the following effects:
the externally drawn terminals with the same polarity arranged on a casing can be interconnected easily by using simple straight conductor bars without the need to use external connecting strips with complex shapes, even if various semiconductor chip sets assembled in a module are used by being connected in parallel, making the product more convenient to use;
an assembly error committed in attaching the case can be avoided, as can defective products;
moulding resin can be injected through the resin-injecting holes while allowing the resin to flow smoothly within the casing, adequately filling up every corner leaving no parts insufficiently filled, thereby improving product quality;
fewer parts are required, thereby requiring fewer man-hours for soldering, and the case where the semiconductor chip set is divided into various chip pieces and internally connected in parallel can be dealt with easily, thereby reducing production costs;
the enclosing case can be filled with moulding resin efficiently with the injection work consuming less time, thereby improving productivity;
it is possible to easily recognize the polarities and arrangements of the terminals on the products from the arrangement pattern of the resin-injecting holes so that, when attaching such products to different devices, it is possible to obtain advantages such that the assembly work can be carried out efficiently by observing the arrangement pattern for the resin-injecting holes without the need to check the terminal symbol marks on the cases one by one.

## Claims

1. A semiconductor device consisting of a plurality of semiconductor chips (D1, D2) contained within an enclosing case (6) filled with moulding resin and having electrical terminals of a first and second polarity connected to respective main electrodes of each semiconductor chip, each of said terminals of the first polarity comprising a chip base (5) and a portion perpendicular to said chip base, said portion further comprising a riser part and an externally drawn terminal (1K, 2K); each of said terminals of the second polarity comprising a terminal leg and a portion perpendicular to said terminal leg, said portion further comprising a rising part and an externally drawn terminal (1A, 2A); said electrical terminals are arranged side by side and said externally drawn terminals are drawn out through the top of the case (6), characterised in that the externally drawn terminals of the first polarity (1K, 2K) are arranged in a first straight line while the externally drawn terminals of the second polarity (1A, 2A) are arranged in a second straight line parallel to the first straight line, and that the externally drawn terminals of different polarities of each respective semiconductor chip are arranged in a row extending perpendicularly to said straight lines; in that the width (W1) of said riser part and the width (W2) of said rising part are different from each other; in that terminal drawing slots (14A, 14K) are disposed in said top of the case having sizes corresponding individually to said widths (W1, W2) of said riser and rising parts; in that each semiconductor chip is mounted on said chip base of said terminal of first polarity, and each externally drawn terminal of second polarity is linked with the top of each of said semiconductor chips; and notches (12), which function as paths for the sealing resin injected into the case, are formed on the riser part of said terminals of first polarity.

2. A semiconductor device according to claim 1, characterised in that chip connecting parts (13, 13a) bent in a C-shape are integrally formed at the terminal legs of said terminals of second polarity, and that said chip connecting parts are soldered on said main electrodes of the semiconductor chips.

3. A semiconductor device according to claim 2, characterised in that the chip connecting parts (13, 13a) are formed as branches extending laterally from the terminals of second polarity and that said branches are bent in a C-shape.

4. A semiconductor device according to any preceding claim, characterised in that the resin-injection holes are disposed discretely at two or more sites at the top of the case, on which the rows of the externally drawn terminals (1A, 1K) are positioned.

5. A semiconductor device according to claim 4, characterised in that the resin injection holes are disposed with different shapes and sizes so that they can be visually identified.

## Patentansprüche

1. Halbleiteranordnung, die aus einer Mehrzahl von Halbleiterchips (D1, D2) besteht, die im Innern eines umschließenden Gehäuses (6) enthalten sind, das mit Preßharz gefüllt ist und Elektroanschlüsse einer ersten und zweiten Polarität hat, die mit entsprechenden Hauptelektroden jedes Halbleiterchips verbunden sind, wobei jeder der Anschlüsse der ersten Polarität eine Chipbasis (5) und einen Bereich, der lotrecht zur Chipbasis ist, umfaßt, wobei der Bereich ferner ein Anstiegsteil und einen äußerlich herausgezogenen Anschluß (1K, 2K) umfaßt; wobei jeder der Anschlüsse der zweiten Polarität ein Anschlußbein und einen Bereich, der lotrecht zum Anschlußbein ist, umfaßt, wobei der Bereich ferner ein ansteigendes Teil und einen äußerlich herausgezogenen Anschluß (1A, 2A) umfaßt; wobei die Elektroanschlüsse Seite an Seite angeordnet sind und die äußerlich herausgezogenen Anschlüsse durch die Oberseite des Gehäuses (6) ausgezogen sind, dadurch gekennzeichnet, daß die äußerlich herausgezogenen Anschlüsse der ersten Polarität (1K, 2K) in einer ersten geraden Linie angeordnet sind, während die äußerlich herausgezogenen Anschlüsse der zweiten Polarität (1A, 2A) in einer zweiten geraden Linie parallel zur ersten geraden Linie angeordnet sind, und daß die äußerlich herausgezogenen Anschlüsse verschiedener Polaritäten jedes entsprechenden Halbleiterchips in einer Reihe angeordnet sind, die sich lotrecht zu den geraden Linien erstreckt; daß die Breite (W1) des Anstiegsteils und die Breite (W2) des ansteigenden Teils einander verschieden sind; daß die Anschlußausziehschlitze (14A, 14K) mit Größen, die den einzelnen Breiten (W1, W2) der Steigleitungs- und ansteigenden Teile entsprechen, in der Oberseite des Gehäuses angeordnet sind; daß jeder Halbleiterchip auf der Chipbasis des Anschlusses der ersten Polarität angeordnet ist, und jeder äußerlich herausgezogene Anschluß der zweiten Polarität mit der Oberseite jeder der Halbleiterchips verbunden ist; und Aussparungen (12), welche als Wege für das abdichtende Harz funktionieren, das in das Gehäuse gespritzt wurde, am Anstiegsteil der Anschlüsse der ersten Polarität gebildet werden.

2. Halbleiteranordnung nach Anspruch 1, dadurch gekennzeichnet, daß die Chipanschlußteile (13, 13a), die in C-Form gebogen sind, an den Anschlußbeinen der Anschlüsse zweiter Polarität integriert geformt, und daß die Chipanschlußteile an die Hauptelektroden der Halbleiterchips gelötet sind.

3. Halbleiteranordnung nach Anspruch 2, dadurch gekennzeichnet, daß die Chipanschlußteile (13, 13a) als Abzweigungen geformt sind, die sich seitlich von den Anschlüssen zweiter Polarität erstrecken, und daß die Abzweigungen in C-Form gebogen sind.

4. Halbleiteranordnung nach einem der vorstehenden Ansprüche, dadurch gekennzeichnet, daß die Harzeinspritzlöcher an zwei oder mehr Stellen an der Oberseite des Gehäuses getrennt angeordnet sind, an welcher die Reihen der äußerlich herausgezogenen Anschlüsse (1A, 1K) angebracht sind.

5. Halbleiteranordnung nach Anspruch 4, dadurch gekennzeichnet, daß die Harzeinspritzlöcher mit verschiedenen Formen und Größen angeordnet sind, so daß sie visuell erkannt werden können.

## Revendications

1. Dispositif à semi-conducteurs constitué par une pluralité de puces (D1, D2) à semi-conducteurs contenues dans un boîtier d'enveloppement (6) rempli de résine de moulage et ayant des bornes électriques d'une première et d'une seconde polarité connectées à des électrodes principales respectives de chaque puce à semi-conducteurs, chacune desdites bornes de la première polarité comportant un substrat (5) de puce et une portion perpendiculaire audit substrat de puce, ladite portion comportant en outre une partie dressée et une borne (1K, 2K) tirée vers l'extérieur; chacune desdites bornes de la seconde polarité comportant une cosse et une portion perpendiculaire à ladite cosse, ladite portion comportant en outre une partie montante et une borne (1A, 2A) tirée vers l'extérieur; lesdites bornes électriques sont disposées côte à côte et lesdites bornes tirées vers l'extérieur sont tirées à travers le dessus du boîtier (6), caractérisé en ce que les bornes (1K, 2K) de la première polarité, tirées vers l'extérieur, sont disposées sur une première ligne droite alors que les bornes (1A, 2A) de la seconde polarité, tirées vers l'extérieur; sont disposées sur une deuxième ligne droite parallèle à la première ligne droite, et en ce que les bornes des différentes polarités, tirées vers l'extérieur, de chaque puce à semi-conducteurs respective sont disposées sur une rangée s'étendant perpendiculairement auxdites lignes droites; en ce que la largeur (W1) de ladite partie montante et la largeur (W2) de ladite partie montante sont différentes l'une de l'autre; en ce que des fentes (14A, 14K) d'extraction de bornes sont ménagées dans ledit dessus du boîtier, leurs dimensions correspondant individuellement auxdites largeurs (W1, W2) desdites parties dressées et montantes; en ce que chaque puce à semi-conducteurs est montée sur ledit substrat de puce de ladite borne de la première polarité, et chaque borne de la seconde polarité, tirée vers l'extérieur, est reliée au dessus de chacune desdites puces à semi-conducteurs; et des encoches (12), qui servent de passages pour la résine d'étanchéité injectée dans le boîtier, sont formées sur la partie dressée desdites bornes de la première polarité.

2. Dispositif à semi-conducteurs selon la revendication 1, caractérisé en ce que des parties de connexion (13, 13a) de puces courbées en forme de C sont formées d'une seule pièce sur les cosses desdites bornes de la seconde polarité, et en ce que lesdites parties de connexion de puces sont fixées par brasage sur lesdites électrodes principales des puces à semi-conducteurs.

3. Dispositif à semi-conducteurs selon la revendication 2, caractérisé en ce que les pièces de connexion (13, 13a) de puces constituent des ramifications s'étendant latéralement depuis les bornes de la deuxième polarité et en ce que lesdites ramifications sont courbées en forme de C.

4. Dispositif à semi-conducteurs selon l'une quelconque des revendications précédentes, caractérisé en ce que les trous d'injection de résine sont disposées séparément à deux endroits ou plus sur le dessus du boîtier, les rangées des bornes (1A, 1K) tirées vers l'extérieur étant disposées à ces endroits.

5. Dispositif à semi-conducteurs selon la revendication 1, caractérisé en ce que les trous d'injection de résine sont disposés avec des formes et des dimensions différentes de façon à pouvoir être identifiés visuellement.
